**Europäisches Patentamt**

**European Patent Office**

**Office européen des brevets**

(19)

(11) Veröffentlichungsnummer : **0 259 403 B1**

(12) **EUROPÄISCHE PATENTSCHRIFT**

(45) Veröffentlichungstag der Patentschrift :
08.04.92 Patentblatt 92/15

(51) Int. Cl.$^5$ : **H03F 1/30**

(21) Anmeldenummer : **87901418.1**

(22) Anmeldetag : **30.01.87**

(86) Internationale Anmeldenummer :
**PCT/EP87/00041**

(87) Internationale Veröffentlichungsnummer :
**WO 87/05171 27.08.87 Gazette 87/19**

(54) **VERFAHREN ZUR COMPENSATION DER OFFSET-SPANNUNG EINES REGELVERSTÄRKERS UND SCHALTUNGSANORDNUNG ZUR DURCHFÜHRUNG DES VERFAHRENS.**

(30) Priorität : **21.02.86 DE 3605561**

(43) Veröffentlichungstag der Anmeldung :
**16.03.88 Patentblatt 88/11**

(45) Bekanntmachung des Hinweises auf die
Patenterteilung :
**08.04.92 Patentblatt 92/15**

(84) Benannte Vertragsstaaten :
**AT BE CH DE FR GB IT LI LU NL SE**

(56) Entgegenhaltungen :
**US-A- 3 609 365**

(56) Entgegenhaltungen :
**US-A- 4 229 703**
**US-A- 4 494 551**
**Electronics, Band 54, Nr. 16, August 1981,
(New York, US), R. Kash et al.: "Building quality analog circuits with C-MOS logic arrays",
Seiten 109-112**

(73) Patentinhaber : **Deutsche Thomson-Brandt
GmbH**
**Hermann-Schwer-Strasse 3 Postfach 1307**
**W-7730 Villingen-Schwenningen (DE)**

(72) Erfinder : **KURZ, Arthur**
**Wikingerstrasse 45**
**W-7516 Langensteinbach (DE)**

EP 0 259 403 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Schaltungsanordnung zur Kompensation der Offsetspannung an einem Regelverstärker.

Regelverstärker werden z.B. in Fokus- und Trackregelkreisen bei optischen Abtastsystemen von CD-Plattenspielern eingesetzt. Bei CD-plattenspielern werden die Nutzsignale, z.B. Ton- oder Videosignale, die auf einer CD-Platte in spiral- oder kreisförmigen Datenspuren gespeichert sind, mittels eines optischen Systems ausgelesen. Das optische System besteht in der Regel aus einer Linsenanordnung, deren Linsen mittels des Fokus-Regelkreises so in axialer Richtung verschoben werden, daß der Brennpunkt der Linsenanordnung auf der CD-Platte liegt. Man nennt diesen Regelvorgang, der im Prinzip der Scharfeinstellung eines Fernrohres entspricht, Fokussierung. Damit die Nutzsignale mittels des optischen Systems von der CD-Platte einwandfrei ausgelesen werden können, ist eine dauernde Fokussierung durch den Fokus-Regelkreis nötig. Weil bereits geringe Abweichungen von der Scharfeinstellung zu Fehlern beim Lesen der auf der CD-Platte abgespeicherten Nutzsignale führen, darf die Offset-Spannung des Regelverstärkers nicht zu groß. werden. Sie muß deshalb kompensiert werden.

Aus der US-A- 4 229 703 ist eine Schaltungsanordnung zur Kompensation der Offset-Spannung eines Verstärkers bekannt.

Der erste Ausgans eines Mikroprozessors ist mit einem ersten Digital-Analog-Wandler verbunden, der zweite Ausgang des Mikroprozessor mit dem. Eingang eines zweiten Digital-Analog-Wandlers. Der Ausgang des ersten Digital-Analog-Wandlers ist mit dem nichtinvertierenden Eingang eines Verstärkers verbunden, während der Ausgang des zweiten Digital-Analog-Wandlers mit dem invertierenden Eingang des Verstärkers verbunden ist, dessen Ausgang über einen Widerstand und einen weiteren Verstärker mit dem invertierenden Eingang eines ersten Vergleichers und mit dem nichtinvertierenden Eingang eines zweiten Vergleichers verbunden ist. Eine Serienschaltung aus vier Widerständen liegt zwischen einer positiven und einer negativen Spannung. Der Verbindungspunkt der beiden mittleren Widerstände der Serienschaltung liegt auf Masse. Der nichtinvertierende Eingang des ersten Vergleichers ist mit dem Verbindungspunkt des ersten und zweiten Widerstandes, der invertierende Eingang des zweiten Vergleichers mit dem Verbindungspunkt des dritten und vierten Widerstandes der Serienschaltung verbunden. Die Ausgänge der beiden Vergleicher sind mit dem Mikroprozessor verbunden.

Die digitalen Werte, die der Mikroprozessor an seinem Ausgang abgibt, wandeln die Digital-Analog-Wandler in je eine analoge Kompensationsspannung um, die an den Eingängen des Verstärkers anliegen. Wenn die Stromstärke im Nano- bis Mikroamperebereich liegt, ist die Schleife mit dem ersten Digital-Analog-Wandler aktiv, dagegen ist bei Strömen oberhalb des Mikroamperebereichs der zweite Digital-Analog-Wandler in der anderen Schleife in Betrieb. Der Mikroprozessor ändert die digitalen Werte an seinem Ausgang so lange, bis ihm die Vergleicher anzeigen, daß die Spannung am Ausgang des Verstärkers in einem vorgegebenen Fenster liegt. Der Mikroprozessor hat jetzt die richtige Kompensationsspannung gefunden. Wegen der Serienwiderstände an den einen Eingängen der beiden Vergleicher ist die Kompensation der Offset-Spannung jedoch nicht allzu genau.

Aus der Zeitschrift "Electronics", Band 54, Nr. 16, August 1981, New York, US, R. Kash et al.: "Building quality along circuits with C-MOS logic arrays", Seiten 109 bis 112, ist eine Schaltungsanordnung zur Kompensation der Offset-Spannung eines Operationsverstärkers bekannt.

Die Eingangsspannung des Operationsverstärkers wird über einen ersten und einen zweiten Schalter den Eingängen des Operationsverstärkers zugeführt. Über einen dritten und vierten Schalter sind die beiden Eingänge des Operationsverstärkers mit dem invertierenden Eingang eines Vergleichers verbunden, dessen nichtinvertierender Eingang mit dem Ausgang des Operationsverstärkers verbunden ist. Der Ausgang des Vergleichers ist mit einem Speicher verbunden, dessen Ausgänge mit einem Digital-Analog-Wandler verbunden sind, der als Widerstandsleiter aus mehreren Widerständen und Schaltern aufgebaut ist. Zwei Ausgänge des Digitale-Analog-Wandlers sind mit zwei Steuereingängen des Operationsverstärkers verbunden.

Um die Offset-Spannung des Operationsverstärkers zu kompensieren, trennen der erste und der zweite Schalter die Eingänge des Operationsverstärkers von der Eingangsspannung. Der dritte und der vierte Schalter verbinden die Eingänge des Operationsverstärkers mit den Eingängen des Vergleichers. Mittels des als Widerstandsleiter aufgebauten Digital-Analog-Wandlers, dessen Schalter vom Speicher angesteuert werden, wird die Offset-Spannung des Operationsverstärkers kompensiert. Wenn die Schalter der Widerstandsleiter in der richtigen Stellung sind, werden der dritte und der vierte Schalter geöffnet, während der erste und der zweite Schalter geschlossen werden, um die Eingangsspannung wieder an die Eingänge des Operationsverstärkers legen zu können. Nachdem die richtige Kompensationsspannung gefunden ist, trennen der dritte und der vierte Schalter den Vergleicher wieder vom Operationsverstärker.

Diese Schaltungsanordnung hat zwar den Vorteil, daß sie die Offset-Spannung sehr genau kompensiert, andererseits aber ist sie mit dem Nachteil behaftet, daß der Aufwand an Bauteilen verhältnismäßig groß ist, denn es sind mehrere Schalter erforderlich.

Es ist daher Aufgabe der Erfindung, eine Schaltungsanordnung zur Kompensation einer Offset-Spannung eines Regelverstärkers so zu gestalten, daß trotz eines möglichst geringen Aufwands an Bauteilen eine sehr genaue Kompensation der Offset-Spannung erzielt wird.

Die Erfindung löst diese Aufgabe gemäß den im Anspruch 1 angeführten Merkmalen.

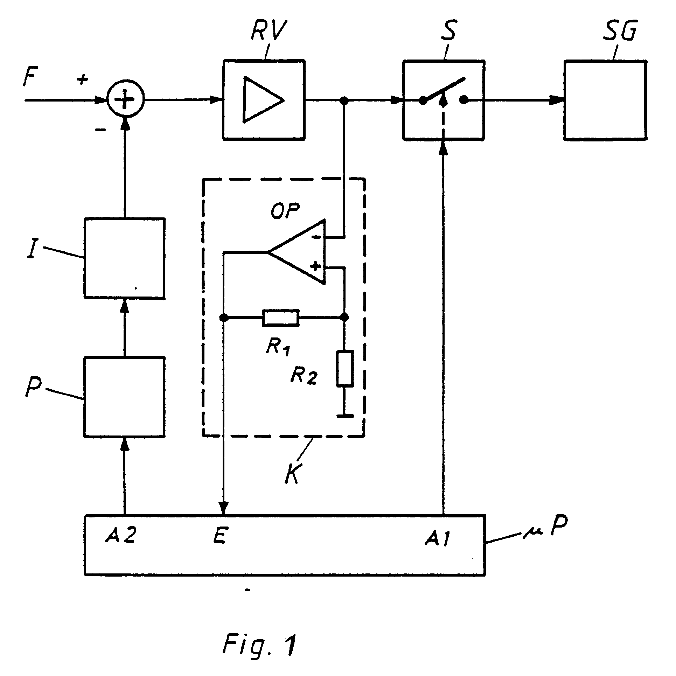

Anhand der in Figur 1 gezeigten und im Anspruch 1 angegebenen Schaltungsanordnung wird die Erfindung erläutert.

Am Eingang des Regelverstärkers RV liegt das Stellsignal F für das Stellglied SG an. Der Ausgang des Regelverstärkers RV ist mit dem invertierenden Eingang eines Operationsverstärkers OP und mit dem einen Kontakt eines steuerbaren Schalters S verbunden, dessen anderer Kontakt mit dem Eingang des Stellgliedes SG verbunden ist. Der Ausgang des Operationsverstärkers OP ist mit dem Eingang E eines Mikroprozessors µP und ihrer einen ersten Widerstand R1 mit seinem nichtinvertierenden Eingang verbunden, der über einen zweiten Widerstand R2 auf Bezugspotential liegt. Ein erster Ausgang A1 des Mikroprozessors µP ist mit dem Steuereingang des steuerbaren Schalters S verbunden. Ein zweiter Ausgang A2 des Mikroprozessors µP ist mit dem Eingang eines Pulsbreitenmodulators P verbunden, dessen Ausgang mit dem Eingang eines Integrators I verbunden ist. Der Ausgang des Integrators I ist mit dem Eingang des Regelverstärkers RV verbunden.

Im folgenden wird die Funktion der Schaltungsanordnung aus Figur 1 erklärt.

Beim Einschalten des Gerätes wird der Fokus-Regelkreis dadurch geöffnet, daß der Mikroprozessor µP den steuerbaren Schalter S durch ein Signal, das er an seinem ersten Ausgang A1 abgibt, öffnet. Der Operationsverstärker OP bildet zusammen mit dem ersten und dem zweiten Widerstand R1 und R2 einen Komparator K, in dem die Offset-Spannung mit der Offset-Referenzspannung verglichen wird. Der Mikroprozessor µP ändert die Spannung an seinem zweiten Ausgang A2 so lange, bis die Offset-Spannung am Ausgang des Regelverstärkers RV mit der Offset-Referenzspannung übereinstimmt, d.h. bis die Offset-Spannung kompensiert ist. Im Mikroprozessor µP wird nun der Wert der Spannung gespeichert, der die Offset-Spannung am Ausgang des Regelverstärkers RV kompensiert. Ausserdem gibt der Mikroprozessor µP an seinem ersten Ausgang A1 ein Signal ab, das den steuerbaren Schalter S und damit auch den Fokus-Regelkreis wieder schließt. Über den Pulsbreitenmodulator P und den Integrator I liegt jetzt dauernd die Kompensationsspannung am Eingang des Regelverstärkers RV an. Bei jedem Wiedereinschalten des Gerätes wird die Offset-Spannung erneut kompensiert.

Der Pulsbreitenmodualtor P kann im Mikroprozessor µP integriert oder durch Software im Mikroprozessor µP realisiert sein.

Ein Vorteil der Erfindung besteht darin, daß bei der Herstellung von CD-Plattenspielern, deren Fokus-Regelkreis nach dem erfindungsgemäßen Verfahren arbeitet, kein Abgleich der Regelverstärker mehr erforderlich ist. Weil jedesmal, wenn das Gerät eingeschaltet wird, die Offset-Spannung von neuem kompensiert wird, wirken sich langfristige Driften der Offset-Spannung infolge Alterung der Bauelemente nicht aus. Es kann deshalb nicht der Fall eintreten, daß der Regelverstärker des Fokus-Regelkreises in einem CD-Plattenspieler, der zunächst einwandfrei spielte, bei dem aber nach längerer Zeit die Klangqualität spürbar nachließ, in der Werkstatt neu abgeglichen werden muß. Daß solche Wartungsmaßnahmen bei Geräten entfallen, deren Regelkreise nach dem erfindungsgemäßen Verfahren arbeiten, ist als weiterer Vorteil zu betrachten, denn die Wartung eines Gerätes ist nicht nur für den Kunden unangenehm, sie kostet auch Geld.

## Patentansprüche

1. Schaltungsanordnung zur Kompensation der Offsetspannung eines Regelverstärkers (RV), an dessen Eingang das Stellsignal (F) für ein Stellglied (SG) anliegt und dessen Ausgang mit dem Kontakt eines steuerbaren Schalters (S) verbunden ist, dessen anderer Kontakt mit dem Stellglied (SG) verbunden ist, **dadurch gekennzeichnet**, daß der Ausgang des Regelverstärkers (RV) mit dem invertierenden Eingang eines Operationsverstärkers (OP) verbunden ist, dessen Ausgang mit einem Eingang (E) eines Mikroprozessors (µP) und über einen ersten Widerstand (R1) mit seinem nichtinvertierenden Eingang verbunden ist, daß der nichtinvertierende Eingang des Operationsverstärkers (OP) über einen zweiten Widerstand (R2) auf Bezugspotential liegt, daß ein erster Ausgang (A1) des Mikroprozessors (µP) mit dem Steuereingang des steuerbaren Schalters (S) verbunden ist, daß ein zweiter Ausgang (A2) des Mikroprozessors (µP) mit dem Eingang eines Pulsmodulators (P) verbunden ist, dessen Ausgang mit dem Eingang eines Integrators (I) verbunden ist, und daß der Ausgang des Integrators (I) mit dem Eingang des Regelverstärkers (RV) verbunden ist.

2. Schaltungsanordnung nach Anspruch 1, **dadurch gekennzeichnet,** daß der Pulsmodulator (P) ein Pulsbreitenmodulator ist.

3. Schaltungsanordnung nach Anspruch 1, **dadurch gekennzeichnet,** daß der Pulsmodulator (P) im Mikroprozessor (μP) integriert ist.

4. Schaltungsanordnung nach Anspruch 3, **dadurch gekennzeichnet,** daß der Pulsmodulator (P) durch Software im Mikroprozessor (μP) realisiert ist.

## Claims

1. Circuit arrangement for compensating the offset voltage of an AGC amplifier (RV) to whose input the positioning signal (F) for a positioning element (SG) is applied and whose output is connected to the contact of a controllable switch (S) whose other contact is connected to the positioning element (SG), **characterised in that** the output of the AGC amplifier (RV) is connected to the inverting input of an operational amplifier (OP) whose output is connected to an input (E) of a microprocessor (μP) and via a first resistor (R1) to its non-inverting input, that the non-inverting input of the operational amplifier (OP) lies via a second resistor (R2) at reference potential, that a first output (A1) of the microprocessor (μP) is connected to the control input of the controllable switch (S), that a second output (A2) of the microprocessor (μP) is connected to the input of a pulse modulator (P) whose output is connected to the input of an integrator (I), and that the output of the integrator (I) is connected to the input of the AGC amplifier (RV).

2. Circuit arrangement according to claim 1, **characterised in that** the pulse modulator (P) is a pulse width modulator.

3. Circuit arrangement according to claim 1, **characterised in that** the pulse modulator (P) is incorporated in the microprocessor (μP).

4. Circuit arrangement according to claim 3, **characterised in that** the pulse modulator (P) is brought about by software in the microprocessor (μP).

## Revendications

1. Dispositif de circuit pour la compensation de la tension offset d'un amplificateur de réglage (RV) à l'entrée duquel est appliqué le signal de réglage (F) pour un composant de réglage (SG) et dont la sortie est reliée au contact d'un commutateur (S) pouvant être commandé dont l'autre contact est relié au composant de réglage (SG), **caractérisé en ce que** la sortie de l'amplificateur de réglage (RV) est reliée à l'entrée inverseuse d'un amplificateur opérationnel (OP) dont la sortie est reliée à une entrée (E) d'un microprocesseur (μP) et par une première résistance (R1) à son entrée directe, que l'entrée directe de l'amplificateur opérationnel (OP) est mise sur le potentiel de référence par une seconde résistance (R2), qu'une première sortie (A1) du microprocesseur (μP) est reliée à l'entrée de commande du commutateur (S) pouvant être commandé, qu'une seconde sortie (A2) du microprocesseur (μP) est reliée à l'entrée d'un modulateur d'impulsions (P) dont la sortie est reliée à l'entrée d'un intégrateur (I) et que la sortie de l'intégrateur (I) est reliée à l'entrée de l'amplificateur de réglage (RV).

2. Dispositif de circuit selon la revendication 1, **caractérisé en ce que** le modulateur d'impulsions (P) est un modulateur d'impulsions en durée.

3. Dispositif de circuit selon la revendication 1, **caractérisé en ce que** le modulateur d'impulsions (P) est intégré au microprocesseur (μP).

4. Dispositif de circuit selon la revendication 3, **caractérisé en ce que** le modulateur d'impulsions (P) est réalisé par un logiciel dans le microprocesseur (μP).

Fig. 1